# EUROPEAN PATENT APPLICATION

(11) **EP 4 742 843 A1**
(43) Date of publication of application: **13.05.2026**
(21) Application number: 24219727.5
(22) Date of filing: 13.12.2024
(51) Int. Cl.: H05K 7/20

(54) **A NOVEL CONNECTOR FOR LIQUID COOLING SYSTEM**

(30) Priority: 11.11.2024 US 202418943148
(71) Applicant: Cooler Master Co., Ltd., Taipei City 114065 (TW)
(72) Inventor: TSENG, Hsiang-Chieh, 114065 Taipei City (TW); CHAN, Wei-Lung, 114065 Taipei City (TW)
(74) Representative: Grünecker Patent- und Rechtsanwälte PartG mbB

(57) **Abstract**

A liquid cooling system includes a first cold plate with a first port and a third port, and a second cold plate with a second port and a fourth port. An inner wall in a housing of each port surrounds a cavity. A first tube is in fluid communication with both the first port and the second port. Each of a first connector and a second connector has diameter portion and a narrow diameter portion, wherein the narrow diameter portions are coupled to opposite ends of the first tube and placed in the first port and the second port, the wide diameter portion is placed in the first port and the second port and includes grooves with O-rings, and each end of the first tube has a portion placed in the housing and spaced apart from the inner wall of the housing by a gap.

## Description

### FIELD OF THE INVENTION

The present disclosure relates to the fluid connectors, and more particularly to the connectors that provide float tolerance for fluid connections between cold plates that are connected by tubes or pipes.

### BACKGROUND

In liquid cooling systems, the fluid connectors are used to connect tubes or pipes to cold plates that require fluid flow for cooling or other similar purposes. Typically, barbed fittings are applied to connect tubes to ports on the cold plates. Specifically, the barb is fixed to the port, and the tube is pushed over the barb to create a secure and fluid-tight connection.

However, this design contain certain drawbacks. The fixed connection between the barb and the port does not allow for any movement of the tube. As a result, the assembly is highly sensitive to misalignments during installation. Any minor deviations in positioning can cause stress on the tube and the connection, leading to potential damage or leaks over time. The rigid connection makes disconnecting and reconnecting tubes during maintenance or component replacements cumbersome. Significant force is often required to remove the tube from the barb, which can damage the tubing or surrounding components, especially in densely packed systems.

The limitations mentioned above are particularly noticeable in applications where it is tough to achieve precise alignment or where frequent maintenance is necessary. The connector or tubing may experience mechanical stress, wear, and eventual failure due to the inability to accommodate axial or angular movement.

### SUMMARY

The present invention provides a solution to these problems by introducing a novel connector design that allows for float tolerance in the axial and angular directions. This design provides flexibility during installation, compensates for misalignments, and makes it easier to swap components without compromising the integrity of the connection.

In one embodiment of the present disclosure, a liquid cooling system for an electronic device includes a first cold plate and a second cold plate that are each thermally coupled to a heat source and spaced apart from one another, a first port on the first cold plate and a second port on the second cold plate, the first and second ports being configured to circulate working fluids between the first cold plate and second cold plate, a third port on the first cold plate and a fourth port on the second cold plate, the third and fourth ports being configured to circulate working fluids between the cold plates and an external heat exchanger, an inner wall in a housing of each port surrounding a cavity, a first tube that is in fluid communication with both the first port and the second port, and a first connector and a second connector that each have a wide diameter portion and a narrow diameter portion, wherein: the narrow diameter portions are coupled to opposite ends of the first tube and are placed in the first port and the second port, respectively, each of the wide diameter portions are placed in the first port and the second port and include grooves with O-rings that are in close contact with the inner wall of the housing, and each end of the first tube has a portion placed in the housing and spaced apart from the inner wall of the housing by a gap.

In one embodiment of the present disclosure, the first tube is a metal hollow tube.

In one embodiment of the present disclosure, a first slot and a second slot are formed on opposite sidewalls of the housing, each of the first slot and the second slot has a portion extending to a top surface of the housing, the first slot and the second slot being configured to receive a clip.

In one embodiment of the present disclosure, the first slot, the second slot and the cavity define a neck portion positioned above the cavity.

In one embodiment of the present disclosure, the clip has a first leg and a second leg placed into the first slot and the second slot respectively, and the first leg and the second leg are connected by a bridging section that is positioned above the neck portion.

In one embodiment of the present disclosure, a third slot is formed above the neck portion, and a tool slot that intersects the third slot, wherein the third slot connects to the first slot and the second slot to form a unified slot, and the tool slot is configured to remove the clip.

In one embodiment of the present disclosure, the bridging section of the clip is hidden by the third slot and is in contact with the neck portion.

In one embodiment of the present disclosure, the first port, the second port, and the unified slot are rectangular in shape.

In one embodiment of the present disclosure, the first port, the second port, and the unified slot are circular in shape.

In one embodiment of the present disclosure, the first tubes are configured to move and shift angularly and axially along an X-axis, a Y-axis and a z-axis, with the X-axis extending longitudinally along the length of the first tube, the Y-axis extending horizontally and being perpendicular to the X-axis, and the Z-axis extending vertically and perpendicular to both the X-axis and the Y-axis.

In one embodiment of the present disclosure, a liquid cooling system in an electronic device includes at least two first cold plates and at least two second cold plates that are alternatively arranged on a motherboard and thermally coupled to a heat source, a first port on each of the first cold plates and a second port on each of the second cold plates, the first and second ports being configure for circulating working fluid between the cold plates, a third port on each of the first cold plates and a fourth port on each of the second cold plates, the third and fourth ports being configured for circulating working fluid between the first cold plates and a second inner manifold, and between the second cold plates and a first inner manifold, respectively, an inner wall in a housing of each port surrounding a cavity, at least two first tubes that are in fluid communication with the first ports and the second ports respectively, and at least two first connectors and at least two second connectors that each have a wide diameter portion and a narrow diameter portion, wherein: the narrow diameter portions are coupled to opposite ends of the first tubes and are placed in the first ports and the second ports, respectively, each of the wide diameter portions are placed in each of the first ports and the second ports and includes grooves with O-rings that are in close contact with the inner wall of the housing, and each end of the first tubes has a portion placed in the housing and spaced apart from the inner wall of the housing by a gap.

In one embodiment of the present disclosure, each of the first soft tubes has a chamber that includes a first barb, a second barb, and a second soft tube.

In one embodiment of the present disclosure, each of the first barb and the second barb is coupled to the second end of the corresponding annular ring, spaced apart, and the first barb and the second barb are in fluid communication through the second soft tube.

In one embodiment of the present disclosure, at least one of the first ports and the second ports and the unified slot are in rectangular shape.

In one embodiment of the present disclosure, the first soft tubes are configured to move and shift angularly and axially along an X-axis, a Y-axis and a z-axis, with the X-axis extending longitudinally along the length of the first tubes, the Y-axis extending horizontally and perpendicular to the X-axis, and the Z-axis extending vertically and perpendicular to both the X-axis and the Y-axis.

In one embodiment of the present disclosure, the cooling system of claim 11, further includes at least two first pipes, at least two second pipes, a first inner manifold that is disposed on a first inner side wall of the electronic and is in fluid communication with the second cold plates via the first pipes, and a second inner manifold that is disposed on a second inner side wall of the electronic device and is in fluid communication with the at least two first cold plates via the second pipes.

In one embodiment of the present disclosure, the first pipes and the second pipes are metal hollow pipes.

In one embodiment of the present disclosure, the first pipes and the second pipes are soft pipes.

In one embodiment of the present disclosure, each of the first pipes including a pair of third barbs that are connected to the fourth port and the first inner manifold, respectively.

In one embodiment of the present disclosure, each of the second pipes including a pair of fourth barbs that are connected to the third port and the second inner manifold, respectively.

### BRIEF DESCRIPTION OF THE DRAWINGS

Aspects of the present disclosure can be understood from the following detailed description when read with the accompanying Figures. It is noted that, in accordance with the standard practice in the industry, various features are not drawn to scale. In fact, the dimensions of the various features may be increased or reduced for clarity of discussion.
FIG. 1 illustrates a perspective view of a liquid cooling system, according to one embodiment of the present disclosure.
FIG. 2A illustrates a perspective view of an exploded liquid cooling system of FIG. 1.
FIG. 2B is a perspective view illustrating the portion of the novel connector in relative detail.
FIG. 2C is a cross-sectional view of the ports, connectors and the tube that are connected together.
FIG. 3A is a side view of the cold plates that are connected by the tube, illustrating that the tube can move and shift along a Z-axis.
FIG. 3B is a plan view of the liquid cooling system, illustrating that the tube can move and shift along a Y-axis.
FIG. 3C is a side view of an interior of port, illustrating that there is a proper clearance between the tube and the inner wall of the housing so that the tube can move and shift angularly.
FIG. 3D is a side view of the cold plates that are connected by the tube, illustrating that the tube can move and shift along an X-axis.
FIG. 4A illustrates a perspective view of the clip system and the slotted configuration for securing the tube, according to one embodiment of the present disclosure.
FIG. 4B illustrates a cross-sectional view of the clip system and the slotted configuration for securing the tube, according to one embodiment of the present disclosure.
FIG. 5A illustrates a perspective view of the clip system and the slotted configuration for securing the tube, according to another embodiment of the present disclosure.
FIG. 5B illustrates a cross-sectional view of the clip system and the slotted configuration for securing the tube, according to another embodiment of the present disclosure.
FIG. 6A illustrates a perspective view of the liquid cooling system, according to another embodiment of the present disclosure.
FIG. 6B illustrates a cross-sectional view of the ports, the connectors, the barbs and the tube that are connected together.
FIG. 7A illustrates a perspective view of the liquid cooling system that is disposed on an electronic device, according to another embodiment of the present disclosure.
FIG. 7B illustrates a perspective view of the liquid cooling system that is not disposed on an electronic device, according to another embodiment of the present disclosure.
FIG. 8A illustrates a perspective view of the clip system and the slotted configuration for securing the tube, according to another embodiment of the present disclosure.
FIG. 8B illustrates a cross-sectional view of the clip system and the slotted configuration for securing the tube along a longitudinal direction, according to another embodiment of the present disclosure.
FIG. 8C illustrates a perspective view of the clip system and the slotted configuration for securing the tube, with part of the housing of the port is taken apart, according to another embodiment of the present disclosure.
FIG. 8D illustrates a cross-sectional view of the clip system and the slotted configuration for securing the tube along a transverse direction, according to another embodiment of the present disclosure.

### DETAILED DESCRIPTION

Detailed descriptions and technical contents of the present invention are illustrated below in conjunction with the accompanying drawings. However, it is to be understood that the descriptions and the accompanying drawings disclosed herein are merely illustrative and exemplary and not intended to limit the scope of the present invention.

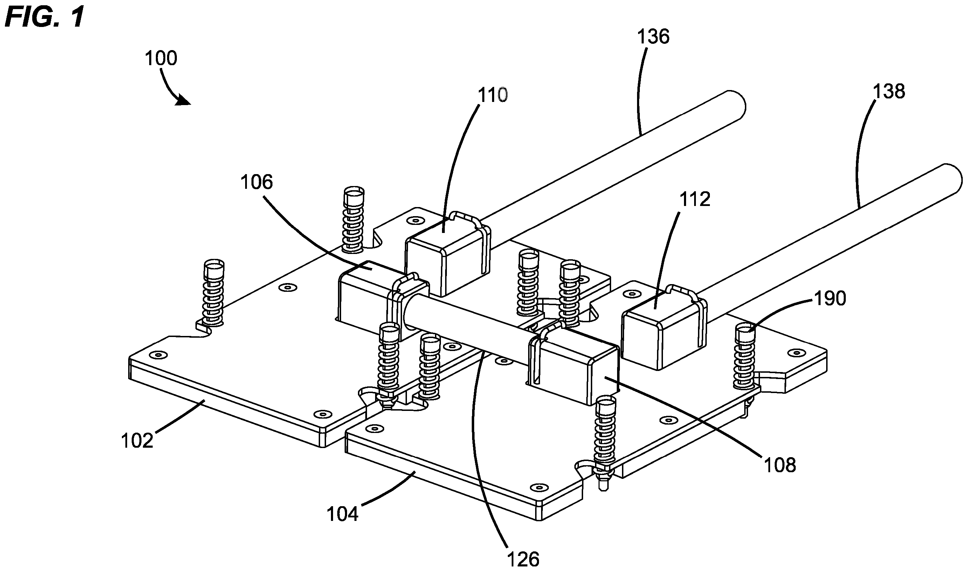

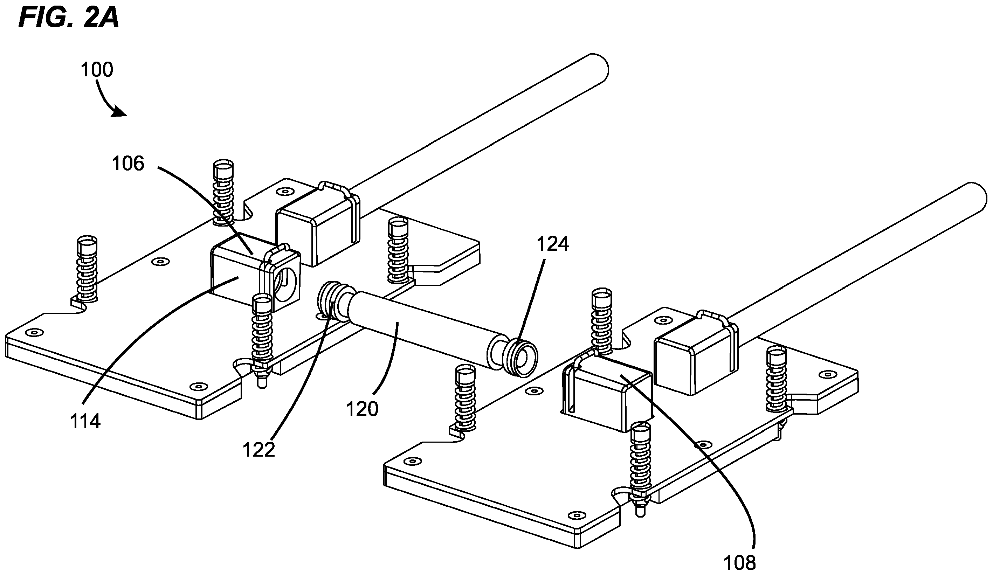

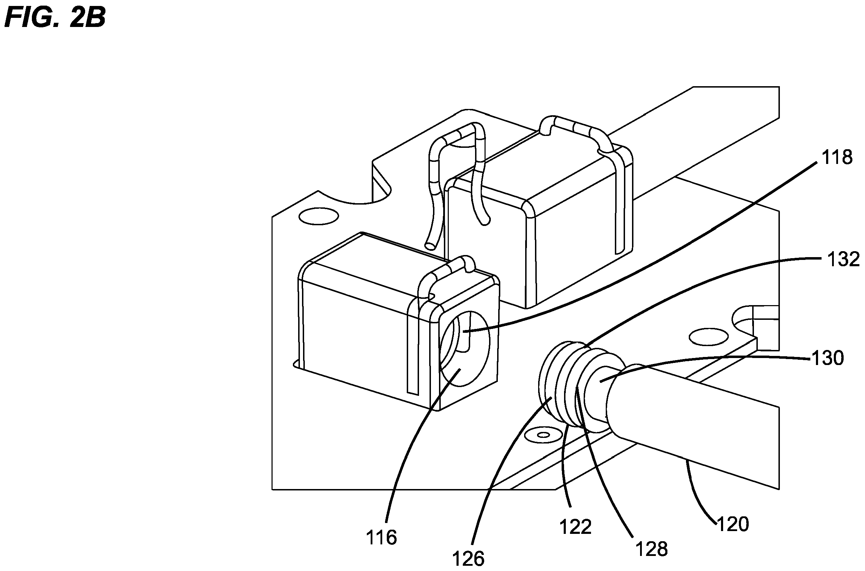

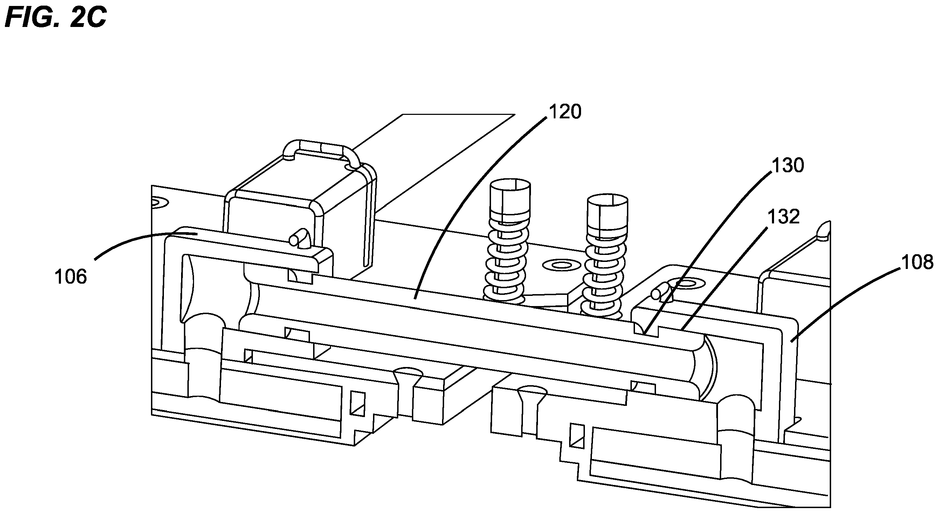

FIG. 1 illustrates a perspective view of a liquid cooling system, according to one embodiment of the present disclosure. FIG. 2A illustrates a perspective view of an exploded liquid cooling system. FIG. 2B is a perspective view illustrating the portion of the novel connector in relative detail. FIG. 2C is a cross-sectional view of the ports, connectors and the tube that are connected together.

Referring to FIG. 1, the liquid cooling system 100 includes a first cold plate 102 and a second plate 104, both made of a thermally conductive material such as copper or aluminum or any suitable material. The first cold plate 102 and the second cold plate 104 are thermally coupled to heat sources like CPUs, GPUs, servers or similar components. The first cold plate 102 and the second cold plate 104 are spaced apart and are positioned on either side of the heat source (not shown), creating a designated pathway for the working fluid (not shown) to flow between them. Each of the first cold plate 102 and the second cold plate 104 includes multiple ports for circulating the working fluid between them and an external heat exchanger.

A first port 106 and a third port 110 are disposed on the first cold plate 102, while a second port 108 and a fourth port 112 are disposed on the second cold plate 104. A first opening direction of the first port 106 is facing to a second opening direction of the second port 108, and a third opening direction of the third port 110 is not facing to a fourth opening direction of the fourth port 112. A third tube 136 and a fourth tube 138 are placed into the third port 110 and the fourth port 112, respectively, configured to connect the cold plates and the heat exchanger. In one embodiment, the housing 114 of the ports is rectangular in shape, providing a large surface area for working fluid to enter and exit, but the embodiment is not limited thereto. In another embodiment, the housing 114 can be circular in shape, providing a more flexible configuration. The liquid cooling system 100 for an electronic device (not shown) further includes a plurality of mounting screws 190 disposed on the first cold plate 102 and the second cold plate 104, being configured to secure fixtures.

Referring to FIG. 2A-2C, each port has a housing 114 with an inner wall 116 that surrounds a cavity 118. The cavity 118 is designed to receive the working fluid from a first tube 120 and direct it into the first cold plate 102 to absorb heat. The first tube 120 is connected to and in fluid communication with both the first port 106 and the second port 108. The first tube 120 allows the working fluid to flow between the first cold plate 102 and the second cold plate 104, carrying heat away from the heat sources. In one embodiment, the first tube 120 is a hollow tube made of metal, such as stainless steel or aluminum, providing durability and high thermal conductivity, but the embodiment is not limited thereto. In another embodiment, the first tube 120 may be made of a flexible material, such as silicone or rubber, and may include internal barbs that are designed to enhance the fluid seal and secure the connection within the ports.

A first connector 122 and a second connector 124 are coupled to each end of the first tube 120, respectively. In one embodiment, each end of the first tube 120 can be machined to form a connecting portion, which is the same as the first connector 122. Both the first connector 122 and the second connector 124 include a wide diameter portion 132 and a narrow diameter portion 130, with a plurality of grooves 126 formed on wide diameter portions 132. A plurality of O-rings 128 are placed into the grooves 126 to create a seal between the first connector 122 and the inner wall of the housing 114. The sealing is important for preventing any working fluid from leaking while flowing between the cold plates.

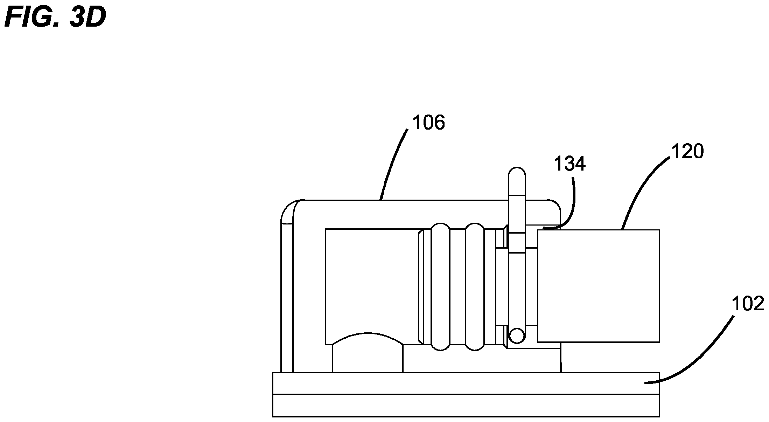

Each end of the first tube 120 is securely placed into the first port 106 and the second port 108, respectively. The first tube 120 is spaced apart from the inner surface 116 of the housing 114 by a minor gap 134. As shown in FIG. 3D, the gap 134 provides a necessary clearance to accommodate angular and axial movement of the tube along the X-axis, Y-axis, and Z-axis, allowing for movement in longitudinal, horizontal, and vertical directions. The configuration provides flexibility during installation and ensures that the tube can adjust to minor misalignments, thermal expansion, or mechanical shifts in the system without compromising the integrity of the fluid seal or causing leakage. The design thereby enhances durability and ease of maintenance in environments where precision alignment may be challenging.

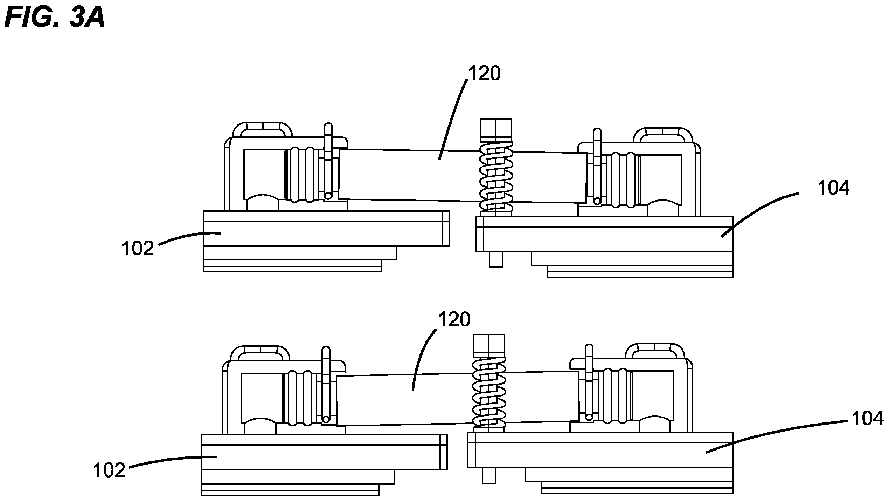

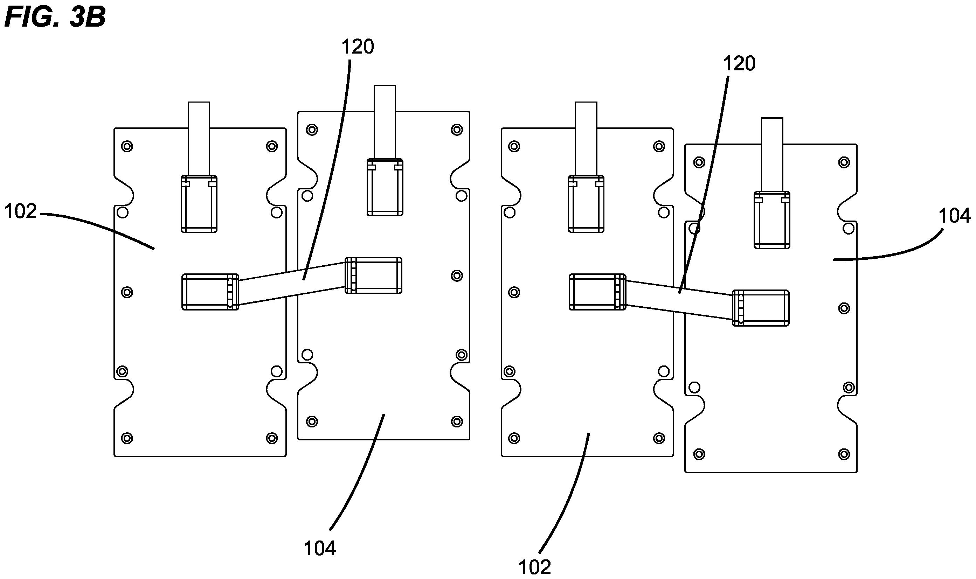

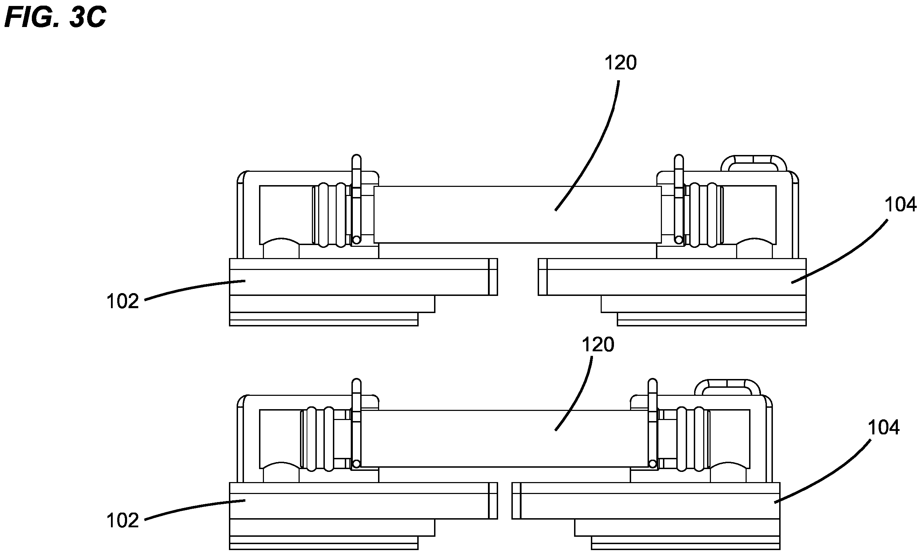

FIG. 3A is a side view of the cold plates that are connected by the tube, illustrating that the tube can move and shift along a Z-axis. FIG. 3B is a plan view of the liquid cooling system, illustrating that the tube can move and shift along a Y-axis. FIG. 3C is a side view of the cold plates that are connected by the tube, illustrating that the tube can move and shift along an X-axis. The X-axis extending longitudinally along the length of the first tube, the Y-axis extending horizontally and being perpendicular to the X-axis, and the Z-axis extending vertically and perpendicular to both the X-axis and the Y-axis. FIG. 3D is a side view of an interior of port, illustrating that there is a proper clearance between the tube and the inner wall of the housing so that the tube can move and shift angularly.

Referring to FIG. 3A, the first cold plate 102 and the second cold plate 104 are positioned at different levels along the Z-axis. The top figure in FIG. 3A shows the first cold plate 102 positioned higher than the second cold plate 104 along the Z-axis, while the bottom figure shows the first cold plate 102 positioned lower than the second cold plate 104 along the Z-axis. The design of the first tube 120 allows for vertical movement and shifting along the Z-axis, enabling it to accommodate the height difference between the two cold plates. The feature provides flexibility in the system, ensuring that the tube can adapt to variations in the relative positions of the cold plates without stressing the connections or compromising the fluid seal, maintaining a reliable and leak-proof system even when misalignment occurs.

Referring to FIG. 3B, the first cold plate 102 and the second cold plate 104 are not aligned along the Y-axis. The right figure in FIG. 3B shows that the first cold plate 102 is further forward than the second cold plate 104 along the Y-axis, while the left figure in FIG. 3B shows that the second cold plate 104 is further forward than the first cold plate 102 along the Y-axis. The design of the first tube 120 allows for horizontal movement and shifting along the Y-axis. The flexibility ensures that the tube can adapt to positional differences between the cold plates without placing undue stress on the connections, thereby maintaining the integrity of the fluid flow and preventing leaks, even when the plates are not perfectly aligned.

Referring to FIG. 3C, the first cold plate 102 and the second cold plate 104 can spaced apart by different distances along the X-axis. The top figure in FIG. 3C illustrates that the distance between the first cold plate 102 and the second cold plate 104 is greater than that in the bottom figure where the first cold plate 102 and the second cold plate 104 are positioned closer together. Because the first tube 120 can move and shift along the X-axis, the variation in spacing between the first cold plate 102 and the second cold plate 104 is allowed. The variation in spacing along the X-axis highlights the flexibility of the system design, allowing the cold plates to be installed at different separations without affecting the functionality of the system.

Referring to FIG. 3D, the first tube 120 is designed to allow for angular movement and shifting because the gap 134 provides a proper clearance for the movement. The gap 134 provides the necessary clearance between the outer surface of the first tube 120 and the inner walls of the housing 114. The clearance afforded by the gap 134 allows the first tube 120 to rotate within a certain range of motion, accommodating angular misalignment or movement in any direction, whether it be along the X-axis, Y-axis, or Z-axis. This capability is critical in scenarios where the system experiences mechanical stress, vibrations, or thermal expansion, ensuring that the tube remains securely connected without compromising the integrity of the fluid seal. The design reduces the risk of wear and tear on the connectors and prevents potential leakage by maintaining a stable connection even when subjected to angular displacement or movement within multiple planes.

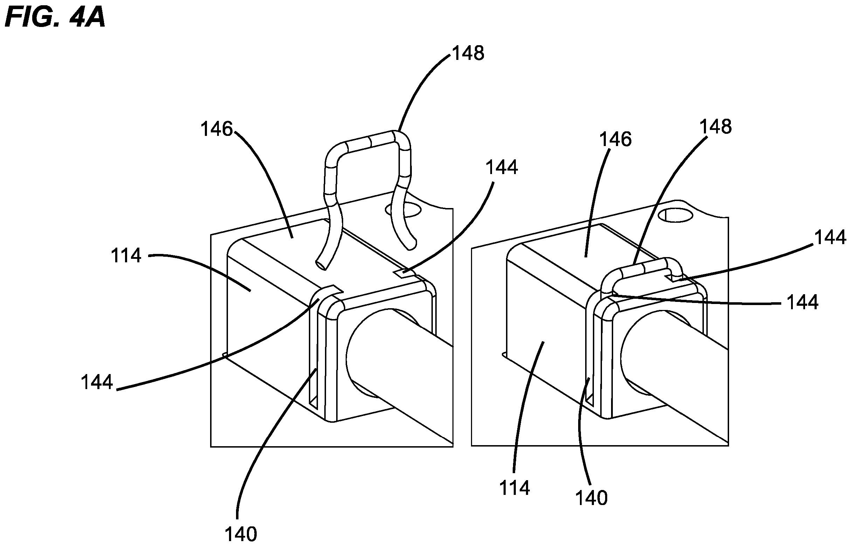

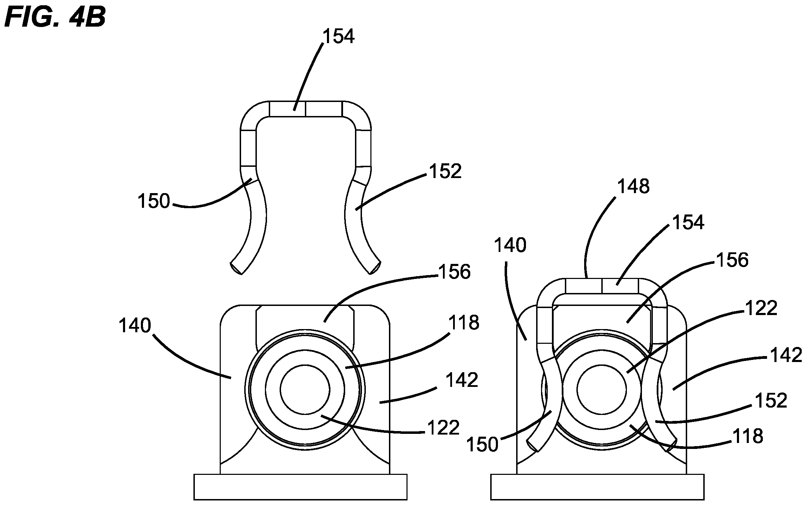

FIG. 4A illustrates a perspective view of the clip system and the slotted configuration for securing the tube, according to one embodiment of the present disclosure. FIG. 4B illustrates a cross-sectional view of the clip system and the slotted configuration for securing the tube, according to one embodiment of the present disclosure.

Referring to FIGS. 4A and 4B, a first slot 140 and a second slot 142 are formed on opposite sidewalls of the housing 114 to further secure the tubes. Each of the first slot 140 and the second slot 142 has a portion 144 that extends to a top surface 146 of the housing 114. A clip 148 is placed into the first slot 140 and the second slot 142 to lock the first connector 122. The first slot 140 and the second slot 142 are designed to provide stability and prevent unwanted movement of the first tube 120 during operation. Both the first slot 140 and the second slot 142 run vertically from the bottom of the two opposite sidewalls of the housing 114 respectively and reach the top surface 146 of the housing 114, ensuring a continuous, robust engagement with the locking mechanism. To lock the first connector 122 into the housing 114 securely, a clip 148 has a first leg 150 and a second leg 152 that are placed into the first slot 140 and the second slot 142, respectively. This clip 148 spans the distance between the first slot 140 and the second slot 142, providing a firm mechanical grip on the first connector 122. It's the same for the second connector 124 locked in to the housing 108.

Referring to FIG. 4B, the first leg 150 and the second leg 152 of clip 148 are connected by a bridging section 154. The first leg 150 and the second leg 152 of the clip 148 are in close contact with the first connector 122 and a neck portion 156 that is positioned above the cavity 118 of the housing 114 and is defined by the first slot 140, the second slot 142 and the cavity 118. The neck portion 156 prevents the clip 148 from jumping out. In one embodiment, the bridging section 154 of the clip 148 is positioned above the neck portion 156 and spaced apart from the neck portion 156, but the embodiment is not limited thereto. In another embodiment, the bridging section 154 of the clip 148 is in close contact with the neck portion 156. The design of the clip 148 ensures that the connector remains fixed in position, even in conditions where the system may experience mechanical stress, thermal expansion, or vibrations. The clip 148 not only locks the first connector 122 securely but also allows for easy removal or adjustment if maintenance is required, ensuring both secure attachment and ease of use.

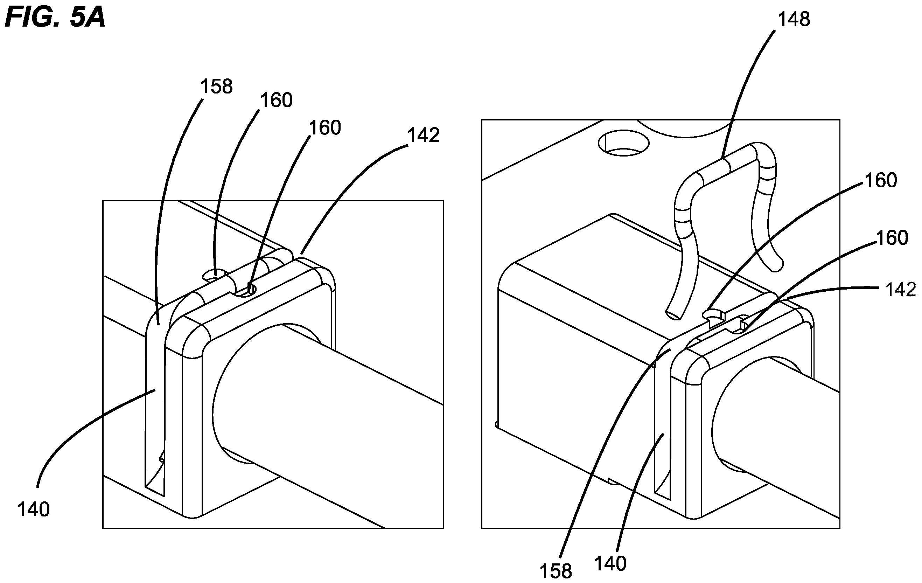

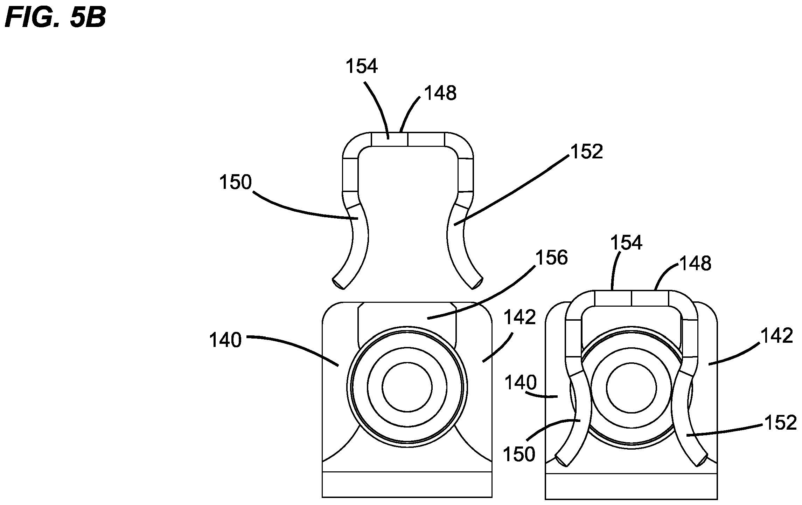

FIG. 5A illustrates a perspective view of the clip system and the slotted configuration for securing the tube, according to another embodiment of the present disclosure. FIG. 5B illustrates a cross-sectional view of the clip system and the slotted configuration for securing the tube, according to another embodiment of the present disclosure.

Referring to FIG. 5A, a third slot 158 is positioned above the neck portion 156 and is formed to integrate with the first slot 140 and the second slot 142, thereby creating a continuous, unified slot structure that is rectangular in shape. A tool slot 160 is precisely aligned to intersect the third slot 158, facilitating the insertion of a tool to remove the clip 148. The first leg 150 and the second leg 152 of the clip 148 are placed into the first slot 140 and the second slot 142, respectively.

Referring to FIG. 5B, the first leg 150 and the second leg 152 of the clip 148 are in close contact with the first connector 122 and the neck portion 156. The bridging section 154 of the clip 148 is in close contact with the neck portion 156 and is hidden by the third slot 158. The third slot 158 hides the bridging section 154 of the clip 148 to avoid incorrect removal of the clip 148.

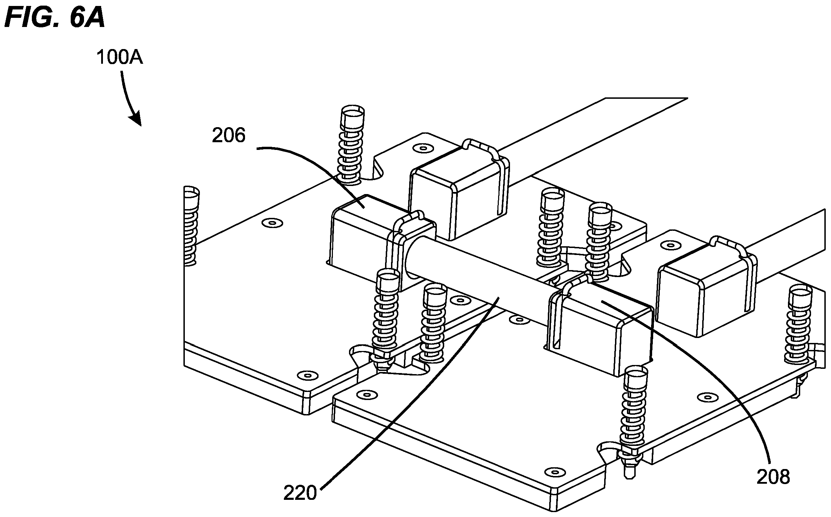

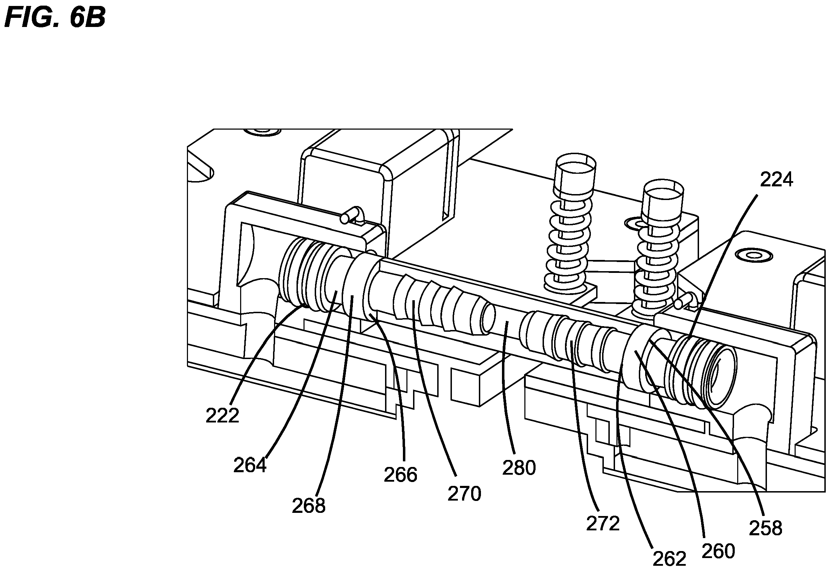

FIG. 6A illustrates a perspective view of the liquid cooling system, according to another embodiment of the present disclosure. FIG. 6B illustrates a cross-sectional view of the ports, the connectors, the barbs and the tube that are connected together.

The liquid cooling system 100A in this embodiment is similar to the liquid cooling system 100 in FIG. 1, so the differences will be described, and the similarities will bit be repeated. Referring to FIG. 6A, the first port 206 and the second port 208 are connected by a first soft tube 220, according to one embodiment of the present disclosure. The soft tube 220, made of flexible and thermally stable materials like silicone or rubber, allows for easier routing of the tubes between the cold plates. The soft tube 220 is in fluid communication with the first port 206 and the second port 208.

Referring to FIG. 6B, a first barb 270 is coupled to a first end 266 of a first annular ring 268, and a second barb 272 is coupled to a first end 262 of a second annular ring 264. The first barb 270 and the second barb 272 are positioned opposing to each other, spaced apart, and connected via the second soft tube 280, which allows for fluid communication between them. The first connector 222 is coupled to a second end 264 of the first annular ring 268, and the second connector 224 is coupled to a second end 258 of the second annular ring 260. Additionally, the first ends of both the first annular ring 268 and the second annular ring 260 are coupled to opposite ends of the first soft tube 220, respectively. In some applications, the barbs create a strong, durable connection that can withstand pressure fluctuations within the fluid system, ensuring consistent and efficient fluid transfer. Further, the soft tubes are highly flexible, allowing the liquid cooling system to accommodate movement or vibration without compromising the integrity of the fluid connection. This is especially useful in dynamic environments where rigid tubes might fail or disconnect.

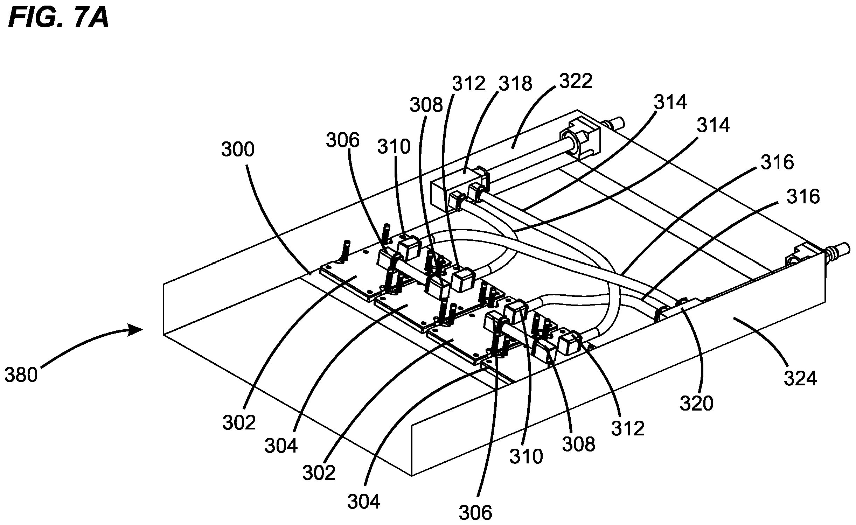

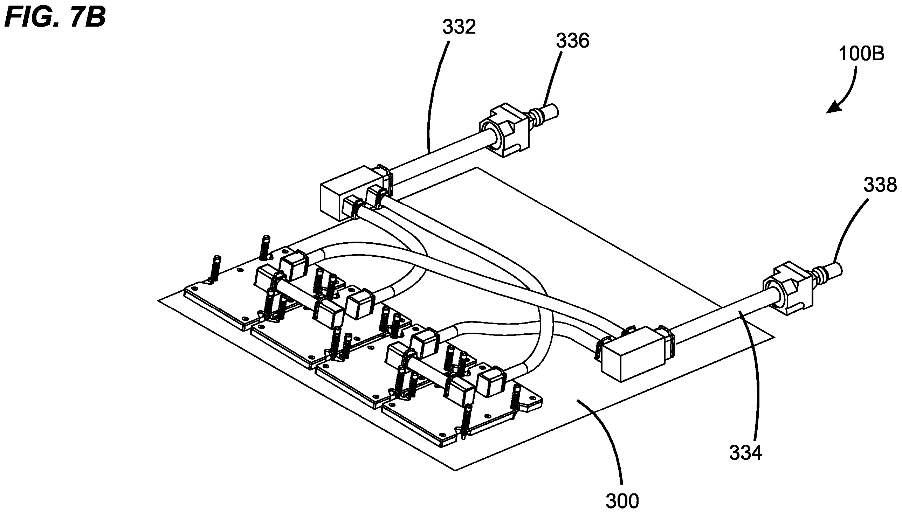

FIG. 7A illustrates a perspective view of the liquid cooling system that is disposed on an electronic device, and FIG. 7B illustrates a perspective view of the liquid cooling system that is not disposed on an electronic device, according to another embodiment of the present disclosure.

The liquid cooling system 100B of this embodiment is similar to the liquid cooling system 100 in FIG. 1, so the differences will be described, and the similarities will not be repeated. Referring to FIG. 7A, the liquid cooling system 100B is expanded to accommodate multiple cold plates arranged in series on a motherboard 300 that is disposed on an electronic device such as servers with multiple CPUs or GPUs.

The liquid cooling system 100B includes at least two first cold plates 302 and at least two second cold plates 304, which are arranged alternatively on the motherboard 300. Each of the first cold plates 302 and the second cold plates 304 is thermally coupled to a corresponding heat source. The first ports 306 on the first cold plates 302 and the second ports 308 on the second cold plates 304 allow the working fluids to circulate between the cold plates, providing efficient thermal management across the entire device.

In one embodiment, the third ports 310 on the first cold plates 302 and the fourth ports 312 on the second cold plates 304 connect the cooling system to an external heat exchanger via pipes and manifolds. The working fluid passes through the first cold plates 302 and second cold plates to absorb heat, and is then directed through the third ports 310 and the fourth ports 312 to the external cooling system, which may include radiators or heat exchangers mounted outside the device.

In one embodiment, the liquid cooling system 100B further includes at least two first pipes 314 and at least two second pipes 316. A first inner manifold 318 is disposed on a first inner side wall 322 of the electronic device 380, wherein the first inner manifold 318 is in fluid communication with the second cold plates 304 via the first pipes 314. A second inner manifold 320 disposed on a second inner side wall 324 of the electronic device 380, wherein the second inner manifold 320 is in fluid communication with the two first cold plates 302 via the second pipes 316.

In one embodiment, the first pipes 314 and the second pipes 316 are metal hollow pipes, providing durability and resistance to high pressure, but the embodiment is not limited thereto. In another embodiment, the first pipes 314 and the second pipes 316 are made of flexible materials, such as soft tubing, to accommodate demands requiring greater flexibility. For the first pipe 314 and the second pipes 316 made of flexible materials, each of the first pipes 314 includes a pair of third barbs (not shown) that are connected to the fourth port and the first inner manifold, respectively. Similarly, each of the second pipes 316 includes a pair of fourth barbs (not shown) that are connected to the third port and the second inner manifold, respectively.

Referring to FIG. 7B, a third tube 332 connects the first inner manifold 318 to a third connector 336, forming a secure and fluid-tight pathway for the exchange of working fluid with external systems. Similarly, a fourth tube 334 connects the second inner manifold 320 to a fourth connector 338, allowing for efficient external fluid exchange. This configuration ensures reliable transfer between the internal manifolds and the external environment.

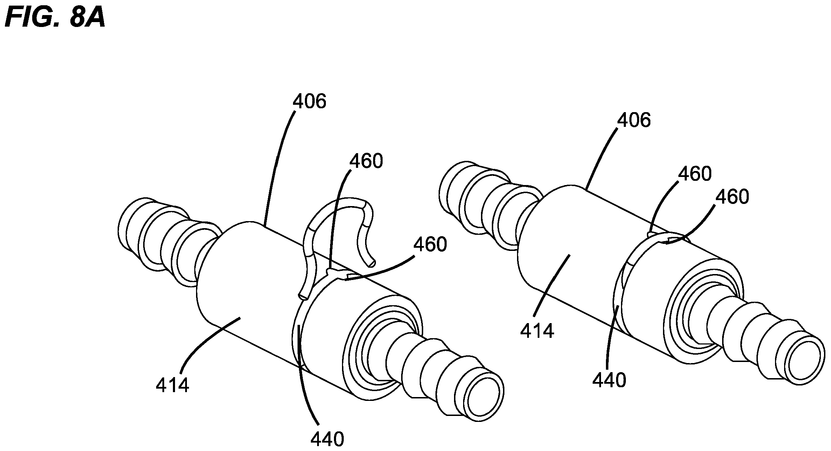

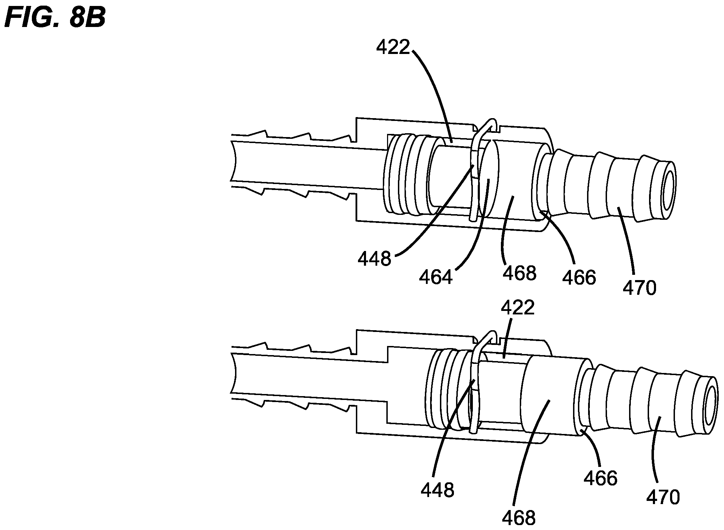

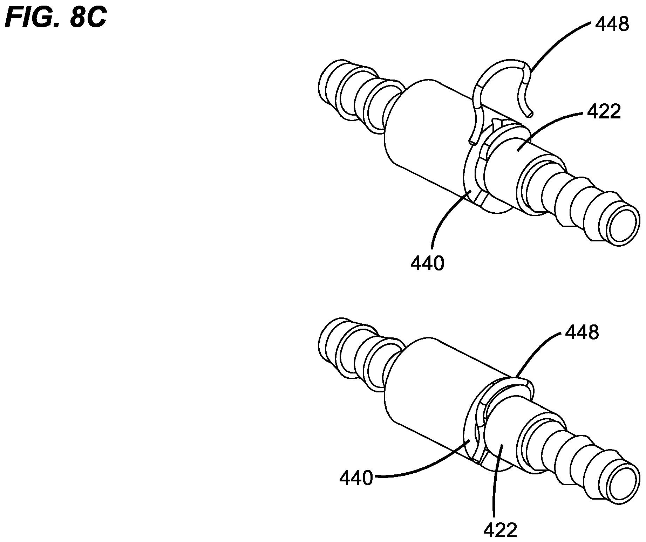

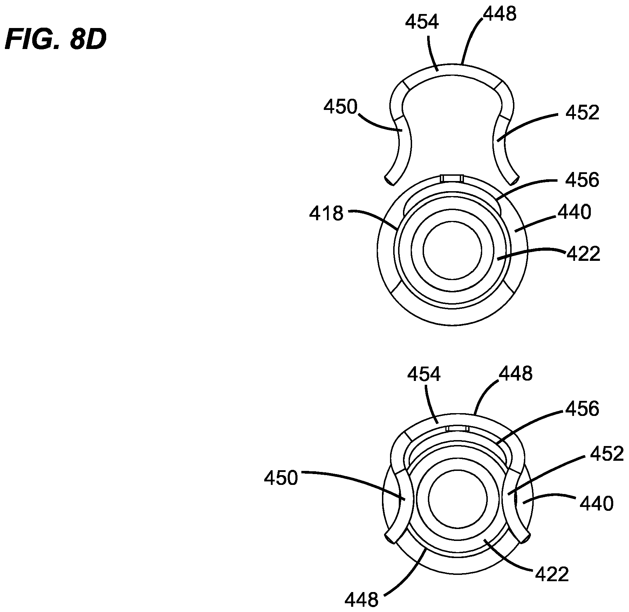

FIG. 8A illustrates a perspective view of the clip system and the slotted configuration for securing the tube, according to another embodiment of the present disclosure. FIG. 8B illustrates a cross-sectional view of the clip system and the slotted configuration for securing the tube along a longitudinal direction, according to another embodiment of the present disclosure. FIG. 8C illustrates a perspective view of the clip system and the slotted configuration for securing the tube, with part of the housing of the port is taken apart, according to another embodiment of the present disclosure. FIG. 8D illustrates a cross-sectional view of the clip system and the slotted configuration for securing the tube along a transverse direction, according to another embodiment of the present disclosure.

In one embodiment, the housing 414 of the ports is circular in shape. Referring to FIG. 8A, the housing 414 of the first port 406 is in a circular shape. The circular shape provides improved structural integrity and uniform stress distribution when securing the tube, reducing potential weak points. A circular slot 440 is precisely formed on the sidewalls of the housing 414, creating a continuous and smooth surface for engagement. A tool slot 460 is precisely aligned to intersect the circular slot 440, allowing easy access for tool insertion and removal.

Referring to FIG. 8B, a first annular ring 468 has a first end 466 and a second end 464 that are coupled to a first barb 470 and the first connector 422, respectively. The clip 448 placed into the circular slot 440 to secure the first connector 422. As shown in the lower figure in FIG.8B, the first barb 470 can move and shift along an X-axis with the X-axis extending longitudinally along the length of the first tube. Additionally, the first barb 470 can move and shift annularly and axially either along a Y-axis with the Y-axis extending horizontally and being perpendicular to the X-axis and or along a Z-axis with, the Z-axis extending vertically and perpendicular to both the X-axis and the Y-axis. This multi-axis movement allows for flexibility in positioning and alignment, enhancing the adaptability of the connector during installation.

Referring to FIG. 8C, the clip 448 is configured to securely place into the circular slot 440 to lock the first connector 422. Referring to FIG. 8D, the first leg 450 and the second leg 452 of the clip 448 are in close contact with the first connector 422 and a neck portion 456 that is defined by the circular slot 440 and the cavity 418. The bridging section 454 of the clip 448 is in close contact with the neck portion 456 and is hidden by the circular slot 440. The circular slot 440 hides the bridging section 454 of the clip 448 to avoid incorrect removal of the clip 448. The circular shape ensures that any forces exerted on the clip 448 and the first connector 422 are evenly distributed around the circumference, reducing the risk of localized stress that could lead to damage or failure.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope and spirit of the present disclosure. Of course, the disclosed embodiments are merely exemplary embodiments and that various modifications can be made without departing from the spirit and scope of the disclosure. Further, it should be understood that various aspects of the embodiment are not mutually exclusive of each other and can be combined as desired by a person of ordinary skill in the art as a matter of design choices.

The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of' the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the elements that it introduces.

## Claims

1. A liquid cooling system (100, 100A, 100B) for an electronic device (380) comprising:
a first cold plate (102, 302) and a second cold plate (104, 304) that are each thermally coupled to a heat source and spaced apart from one another;
a first port (106, 206, 306, 406) on the first cold plate (102, 302) and a second port (108, 208, 308) on the second cold plate (104, 304), the first (106, 206, 306, 406) and second ports (108, 208, 308) being configured to circulate working fluids between the first cold plate (102, 302) and second cold plate (104, 304);
a third port (110) on the first cold plate (102, 302) and a fourth port (112, 312) on the second cold plate (104, 304), the third (110, 310) and fourth ports (112, 312) being configured to circulate working fluids between the cold plates and an external heat exchanger;
an inner wall (116) in a housing (114, 414) of each port surrounding a cavity (118);
a first tube (120) that is in fluid communication with both the first port (106, 206, 306, 406) and the second port (108, 208, 308); and
a first connector (122, 322, 422) and a second connector (124, 224) that each have a wide diameter portion (132) and a narrow diameter portion (130),
wherein:
the narrow diameter portions (130) are coupled to opposite ends of the first tube (120) and are placed in the first port (106, 206, 306, 406) and the second port (108, 208, 308), respectively,
each of the wide diameter portions (132) are placed in the first port (106, 206, 306, 406) and the second port (108, 208, 308) and include grooves (126) with O-rings that are in close contact with the inner wall (116) of the housing (114, 414), and
each end of the first tube (120) has a portion (144) placed in the housing (114, 414) and spaced apart from the inner wall (116) of the housing (114, 414) by a gap (134).

2. The liquid cooling system (100, 100B) of claim 1, wherein the first tube (120) is a metal hollow tube.

3. The liquid cooling system (100, 100A, 100B) of claim 1 or 2, wherein
a first slot (140) and a second slot (142) are formed on opposite sidewalls of the housing (114, 414), each of the first slot (140) and the second slot (142) have a portion (144) extending to a top surface (146) of the housing (114, 414), the first slot (140) and the second slot being configured to receive a clip (148, 448).

4. The liquid cooling system (100, 100A, 100B) of claim 3, wherein
the first slot (140), the second slot (142) and the cavity (118) define a neck portion (156, 456) positioned above the cavity (118).

5. The liquid cooling system (100, 100A, 100B) of claim 4, wherein
the clip (148, 448) has a first leg (150, 450) and a second leg (152, 452) placed into the first slot (140) and the second slot (142) respectively, and the first leg (150, 450) and the second leg (152, 452) are connected by a bridging section (154, 454) that is positioned above the neck portion (156, 456).

6. The liquid cooling system (100, 100A, 100B) of claim 4 or 5, further comprising:
a third slot that is formed above the neck portion (156, 456); and
a tool slot (160) that intersects the third slot (158), wherein the third slot connects to the first slot (140) and the second slot (142) to form a unified slot, and the tool slot is configured to remove the clip (148, 448).

7. The liquid cooling system (100, 100A, 100B) of claim 6, wherein
the bridging section (154, 454) of the clip (148, 448) is hidden by the third slot (158) and is in contact with the neck portion (156, 456).

8. The liquid cooling system (100, 100A, 100B) of claim 6 or 7, wherein
the first port (106, 206, 306, 406), the second port (108, 208, 308), and the unified slot are rectangular in shape.

9. The liquid cooling system (100, 100A, 100B) of claim 6 or 7, wherein
the first port (106, 206, 306, 406), the second port (108, 208, 308), and the unified slot are circular in shape.

10. The liquid cooling system (100, 100A, 100B) of one of claims 1 to 9, wherein
the first tubes (120) are configured to move and shift angularly and axially along an X-axis, a Y-axis and a z-axis, with the X-axis extending longitudinally along the length of the first tube, the Y-axis extending horizontally and being perpendicular to the X-axis, and the Z-axis extending vertically and perpendicular to both the X-axis and the Y-axis.

11. A liquid cooling system (100B) in an electronic device (380), comprising:
at least two first cold plates (302) and at least two second cold plates (304) that are alternatively arranged on a motherboard (300) and thermally coupled to a heat source;
a first port (306) on each of the first cold plates (302) and a second port (308) on each of the second cold plates (304), the first and second ports (308) being configure for circulating working fluid between the cold plates;
a third port (310) on each of the first cold plates (302) and a fourth port (312) on each of the second cold plates (304), the third (310) and fourth ports (312) being configured for circulating working fluid between the first cold plates (302) and a second inner manifold (320), and between the second cold plates (304) and a first inner manifold (318), respectively;
an inner wall (116) in a housing (114, 414) of each port surrounding a cavity (118);
at least two first tubes that are in fluid communication with the first ports (306) and the second ports (308) respectively; and
at least two first connectors and at least two second connectors that each have a wide diameter portion (132) and a narrow diameter portion (130),
wherein:
the narrow diameter portions (130) are coupled to opposite ends of the first tubes and are placed in the first ports (306) and the second ports (308), respectively,
each of the wide diameter portions are placed in each of the first ports (306) and the second ports (308) and includes grooves (126) with O-rings that are in close contact with the inner wall (116) of the housing (114, 414), and
each end of the first tubes has a portion (144) placed in the housing (114, 414) and spaced apart from the inner wall (116) of the housing (114, 414) by a gap (134).

12. The liquid cooling system (100B) of claim 11, wherein each of the first tubes is a metal hollow tube.

13. The liquid cooling system (100B) of claim 11 or12, wherein
a first slot (140) and a second slot (142) are formed on opposite sidewalls of the housing (114, 414) of at least one of the first ports (306) and the second ports (308), each of the first slot (140) and the second slot (142) have a portion (144) extending to a top surface (146) of the housing (114, 414), the first slot (140) and the second slot (142) being configured to receive a clip (148, 448).

14. The liquid cooling system (100B) of claim 13, wherein
the first slot (140), the second slot (142) and the cavity (118) define a neck portion (156, 456) positioned above the cavity (118).

15. The liquid cooling system (100B) of claim 14, wherein
the clip (148, 448) has a first leg (150, 450) and a second leg (152, 452) placed in the first slot (140) and the second slot (142), respectively, and the first leg (150, 450) and the second leg (152, 452) are connected by a bridging section (154, 454) positioned above the neck portion (156, 456).

16. The liquid cooling system (100B) of claim 14 or 15, further comprising:
a third slot that is formed above the neck portion (156, 456); and
a tool slot (160) that intersects the third slot (158), wherein the third slot connects to the first slot (140) and the second slot (142) to form a unified slot, and the tool slot is configured to remove the clip (148, 448).

17. The liquid cooling system (100B) of claim 16, wherein
the bridging section (154, 454) of the clip (148, 448) is hidden by the third slot (158) and is in contact with the neck portion (156, 456).

18. The liquid cooling system (100B) of claim 16 or 17, wherein
at least one of the first ports (306) and the second ports (308) and the unified slot are in rectangular shape.

19. The liquid cooling system (100B) of claim 16 or 17, wherein
at least one of the first ports (306) and the second ports (308) and the unified slot are in circular ship.

20. The liquid cooling system (100B) of claim 11, wherein
the first soft tubes are configured to move and shift angularly and axially along an X-axis, a Y-axis and a z-axis, with the X-axis extending longitudinally along the length of the first tubes (120), the Y-axis extending horizontally and perpendicular to the X-axis, and the Z-axis extending vertically and perpendicular to both the X-axis and the Y-axis.

21. The liquid cooling system (100B) of one of claims 11 to 20, further comprising:
at least two first pipes (314);
at least two second pipes (316);
a first inner manifold (318) that is disposed on a first inner side wall (322) of the electronic and is in fluid communication with the second cold plates (304) via the first pipes (314); and
a second inner manifold (320) that is disposed on a second inner side wall (324) of the electronic device (380) and is in fluid communication with the at least two first cold plates (302) via the second pipes (316).

22. The liquid cooling system (100B) of claim 21, wherein the first pipes (314) and the second pipes (316) are metal hollow pipes.

23. The liquid cooling system (100B) of claim 21, wherein the first pipes (314) and the second pipes (316) are soft pipes.

24. The liquid cooling system (100B) of claim 23, wherein
each of the first pipes (314) including a pair of third barbs that are connected to the fourth port (112) and the first inner manifold (318), respectively.

25. The liquid cooling system (100B) of claim 23, wherein
each of the second pipes (316) including a pair of fourth barbs that are connected to the third port (310) and the second inner manifold (320), respectively.
